# DEMANDE DE BREVET EUROPEEN

(11) **EP 2 765 536 A1**
(43) Date de publication de la demande: **13.08.2014**
(21) Numéro de dépôt: 13305150.8
(22) Date de dépôt: 07.02.2013
(51) Int. Cl.: G06K 19/077

(54) **Procédé de connexion d'un microcircuit à des zones conductrices accessibles dans un support**

(71) Demandeur: Gemalto SA, 92190 Meudon (FR)
(72) Inventeur: Ottobon, Stéphane, 13705 La Ciotat (FR); Dossetto, Lucile, 13705 La Ciotat (FR); Seban, Frédérick, 13705 La Ciotat (FR); Audouard, Laurent, 13705 La Ciotat (FR)

(57) **Abrégé**

Procédé de connexion d'un microcircuit à des zones conductrices accessibles dans un support

L'invention concerne un procédé de connexion de plages conductrices (9) d'un micromodule (2) à des zones de connexion (3a, 3b) accessibles d'un support (1) d'un objet portable (100), comprenant les étapes suivantes de :
- fourniture ou réalisation d'un corps (1) de l'objet portable (100) comportant une cavité (11) de réception du micromodule et des zones de connexion accessibles dans ladite cavité, ladite cavité débouchant en surface du corps et étant délimitée à la surface du corps par une première périphérie (P1),
- réalisation d'un micromodule comprenant des plages de contact électrique (9) sur une face avant, délimitées par une seconde périphérie P2 correspondant sensiblement à la première périphérie P1, des portions de connexion (10) repliées vers une face arrière du micromodule opposée à la face avant,
- insertion du module dans la cavité, lesdites portions de connexion étant mises en connexion électrique avec leur zone de connexion (3a, 3b) respective,

caractérisé en ce que lesdites portions de connexion s'étendent à partir de la seconde périphérie (P2) des plages de contact et sont configurées de manière qu'en position repliée, elles exercent une force de contact contre les zones de connexion.

L'invention concerne également l'objet obtenu.

## Description

### Domaine de l'invention.

L'invention concerne un procédé de connexion d'un microcircuit à des zones ou pistes conductrices accessibles dans un support

Dans le domaine des cartes à puce électronique, l'invention vise un procédé de connexion d'un micromodule comprenant un microcircuit, à des pistes conductrices noyées ou accessibles dans un corps de carte ou dans un corps d'insert. Les cartes à puce sont réglementées notamment par la norme ISO 7816.

L'invention peut être utilisée pour connecter des claviers, des afficheurs, des capteurs équipant notamment des cartes multi-composant.

L'invention peut concerner des objets portables électroniques par exemple des cartes à mémoire telles que de type SD (de la société Sandisk) ou des passeports électroniques, clés électroniques, des cartes à interface duale ou hybride (contact et sans-contact).

### Art antérieur.

Le brevet US 5 598 032 décrit un procédé de connexion d'un micromodule à une antenne formée dans une couche intérieure d'un corps support. L'antenne noyée dans le corps comprend des extrémités de connexion pour connecter des plages de contact du micromodule. Ces extrémités sont accessibles au fond d'au moins une cavité débouchant à la surface du corps support ; Elles sont connectées par tout moyen de raccordement aux plages de contact du micromodule. Parmi ces moyens de connexion, on trouve notamment des languettes ressorts glissées dans des puits de connexion ou de la colle conductrice remplissant ces puits.

Le brevet US 5 856 912 (figures 1, 2)décrit un assemblage d'un microcircuit électronique sur un substrat de carte à puce, comprenant :
- un substrat ayant une face et définissant au moins un trou d'interconnexion ayant une ouverture à travers la face et définissant en outre une cavité de réception d'un module de carte à puce ;
- un circuit électrique disposé à l'intérieur du substrat et comprenant une borne dans la cavité ;
- un module de carte à puce reçu dans la cavité ayant au moins une plage de contact métallique comprenant une patte métallique s'étendant dans le trou d'interconnexion rempli de matière conductrice.

La patte est formée par une découpe de plage de contact s'étendant vers l'intérieur de la surface du module et à l'intérieur d'une périphérie de plage de contacts.

Au pliage de la patte, la découpe de celle-ci est visible de l'extérieur dans la zone des plages de contact. Des creux correspondants apparaissent en surface du module. Le procédé requiert une étape de dépôt de matière conductrice dans les puits de connexion.

L'invention a pour objectif de résoudre les inconvénients précités. L'invention vise notamment à améliorer la fiabilité de connexion du module avec des zones de connexion conductrices enfouies dans un corps support et ce au moindre coût ou avec moins d'étape de fabrication. L'invention recherche donc une connexion électrique plus forte et/ou plus élastique tout en conservant un bon aspect esthétique du module ou en conservant l'intégrité de surface des plages de contacts.

### Résumé de l'invention.

Dans son principe appliqué aux cartes à puce, l'invention prévoit d'utiliser une portion ou excroissance repliée des plages de contact ou d'une portion conductrice de plages conductrices d'un micromodule, située hors de la périphérie des plages de contact pour connecter des surfaces de connexion enfouies dans un support ou situées à distance de la surface principale d'un corps support.

Le repliement s'effectue avant insertion du micromodule dans une cavité ou évidement séparant les plages de contact (plages ou languettes ou pistes conductrices), des zones de connexion ; Le repliement peut se poursuivre au cours de l'insertion par écrasement des portions de connexion.

L'invention permet d'avoir des plages de contact sur une seule face du module réduisant ainsi les coûts et étapes de fabrication.

L'invention a donc pour objet un procédé de connexion de plages conductrices d'un micromodule à des zones de connexion accessibles d'un support d'un objet portable, comprenant les étapes suivantes de :
- fourniture ou réalisation d'un corps de l'objet portable comportant une cavité de réception du micromodule et des zones de connexion accessibles dans ladite cavité, ladite cavité débouchant en surface du corps et étant délimitée à la surface du corps par une première périphérie (P1),
- réalisation d'un micromodule comprenant des plages de contact électrique sur une face avant délimitées par une seconde périphérie P2 correspondant sensiblement ou étant légèrement inférieure à la première périphérie P1, des portions de connexion repliées vers une face arrière du micromodule opposée à la face avant,
- insertion du module dans la cavité, lesdites portions de connexion étant mises en connexion électrique avec leur zone de connexion respective.

Le procédé se distingue en ce que lesdites portions de connexion s'étendent à partir de la seconde périphérie (P2) des plages de contact et sont configurées de manière qu'en position repliée, elles exercent une force de contact élastique contre les zones de connexion.

Selon d'autres caractéristiques du procédé :
- Au moins une portion de connexion est configurée en angle sensiblement droit par rapport à la surface du micromodule de manière à se courber élastiquement à l'insertion ;
- Au moins une portion de connexion est configurée de manière à former un zigzag ou ressort élastique et à se déformer élastiquement à l'insertion ;
- Au moins une portion de connexion est configurée de manière à former une inclinaison vers l'intérieur du module et à se déformer élastiquement à l'insertion ;
- Il comprend une étape de comblement au moins partiel de chaque évidement ; Le comblement fixe ou colle uniquement l'extrémité des portions de manière à préserver leur élasticité ;
- La matière de comblement est une matière conductrice effectuant un contact électrique entre uniquement l'extrémité desdites portions de connexion et ladite zone de connexion correspondante.

L'invention concerne également un objet portable comprenant un micromodule comportant des plages de contact électrique sur une face avant délimitées par une seconde périphérie (P2) et des portions de connexion repliées vers une face arrière du micromodule opposée à la face avant. L'objet se distingue en ce que lesdites portions de connexion s'étendent à partir de la seconde périphérie (P2) des plages de contact et sont configurées de manière à exercer une force de contact contre les zones de connexion.

Brève description des figures.
- La figure 1 illustre un module de l'art antérieur en vue de dessus ;
- La figure 2 illustre une vue en coupe de la figure précédente selon B-B ;
- La figure 3A est une vue en perspective d'un micromodule de carte à puce conforme à un mode de réalisation de l'invention ;
- La figure 3B est une vue en coupe longitudinale selon A-A du micromodule de la figure précédente ;
- La figure 4A illustre le micromodule de la figure précédente avec ses portions de connexion repliées selon un premier mode de réalisation ;
- La figure 4B illustre le micromodule de carte à puce de la figure précédente après insertion dans une cavité de corps de carte ;
- La figure 5A illustre un micromodule de carte à puce avec ses portions de connexion repliées selon un second mode de réalisation ;
- La figure 5B illustre le micromodule de la figure précédente après insertion dans une cavité de corps de carte ;
- La figure 5C illustre une vue partielle du micromodule de la figure précédente après une insertion et connexion différentes dans une cavité de corps de carte.

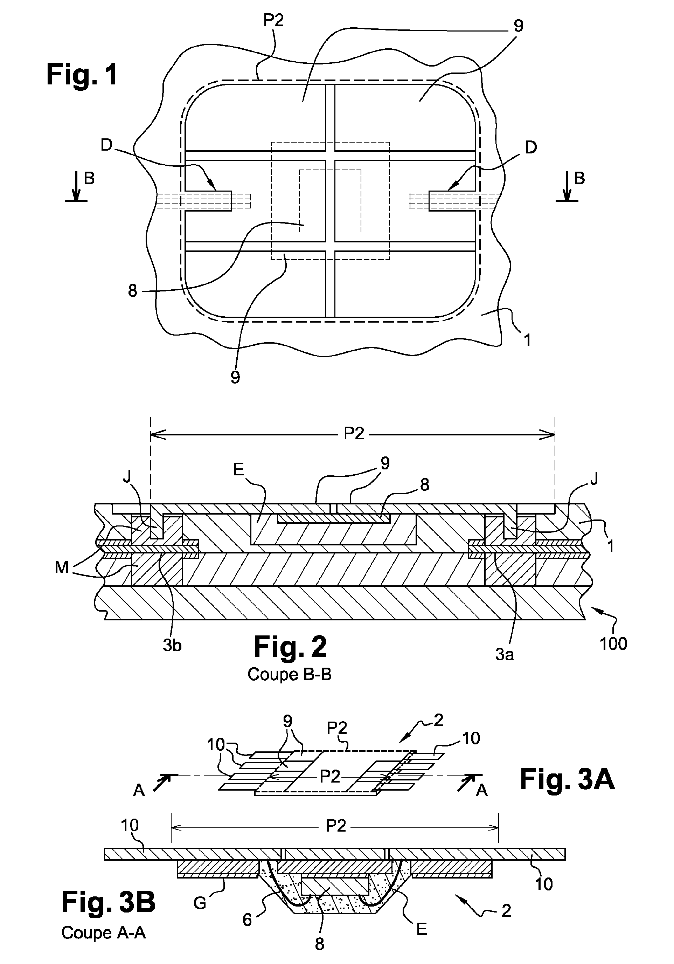

Sur les figures 1-2 illustrant l'art antérieur, un module de type carte à puce 100 comprend des plages de contact 9 à l'intérieur d'une zone de plages de contact ou périphérique P2. Cette ligne fictive périphérique P2 désigne la forme globale des plages de contact et ne comprend pas de partie concave. Cette ligne correspond sensiblement au pourtour de la cavité de réception (plan supérieur de la cavité) du module.

Le module est encarté dans un corps de carte 1. Il comprend des jambes J s'étendant d'une zone sensiblement centrale de plage de contact vers une zone de connexion 3a, 3b à travers des puits. Chaque jambe J formée à l'intérieur d'une plage de contact 9 par une découpe D de celle-ci.

Au pliage, la découpe J de la plage de contact est orientée à 90° par rapport à la surface principale du module.

Des creux correspondant à chaque découpe D apparaissent en surface du module et de la carte à puce 100.

Les jambes J pénètrent dans une matière conductrice remplissant les puits et au contact des zones de connexion (sans connecter directement les zones de connexion). Les jambes sont entièrement prises dans la matière conductrice et ne connectent pas directement les zones de connexion mais à travers la matière conductrice.

L'invention concerne un procédé de connexion de plages conductrices 10 d'un micromodule (2) à des zones de connexion 3a, 3b noyées ou accessibles dans un support 1 d'un objet portable 100.

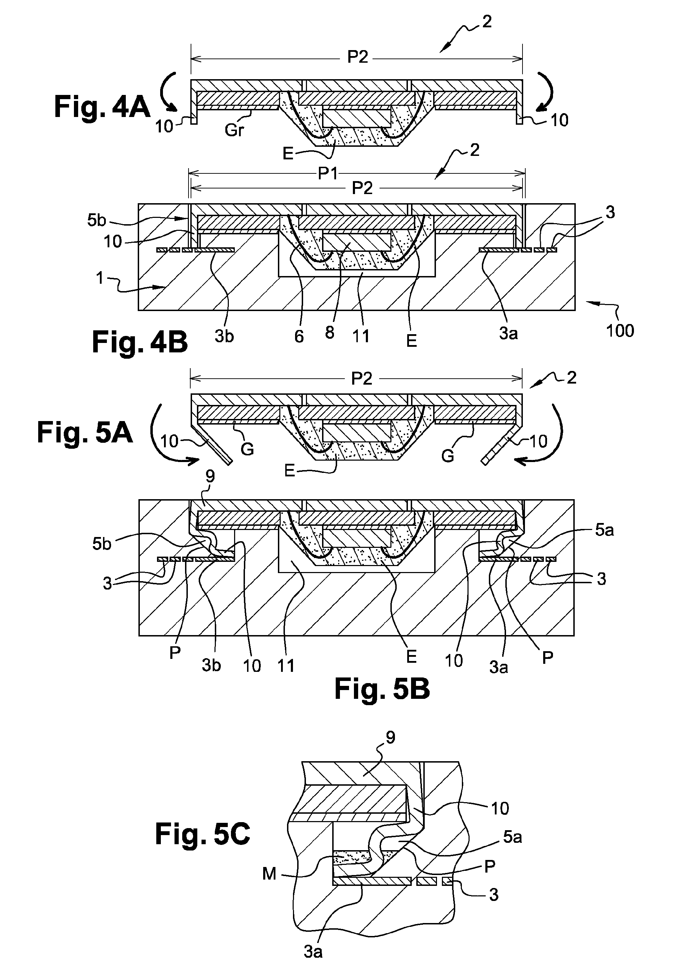

A la figure 4B, selon un mode de réalisation de l'invention, l'objet portable est une carte à puce 100 comprenant un corps support 1 (ici un corps de carte), une antenne 3, et un micromodule 2 encarté dans une cavité 11 du corps support. L'objet portable peut être notamment une carte multi-composant avec notamment un afficheur et/ou un clavier et/ou un capteur. Elle peut être un passeport électronique ou une clé électronique intelligente.

Le procédé comprend une étape de fourniture ou de réalisation d'un corps de l'objet portable 1 comportant une cavité 11 de réception du micromodule et des zones de connexion 3a, 3b accessibles dans ladite cavité. La cavité débouche en surface du corps et est délimitée à la surface du corps par une première périphérie,

Dans le premier mode de réalisation, on réalise un corps de la carte à puce avec une cavité 11 ici à deux niveaux et des plages de connexion 3a, 3b d'une antenne radiofréquence 3 enfouie dans le corps de carte. La carte est par exemple obtenue par lamination de feuilles ou surmoulage d'un circuit électrique / électronique notamment supportée per une feuille. La cavité définit une première périphérie P1 ou un pourtour de la cavité la plus étendue débouchant en surface du corps de l'objet.

La cavité P1 et /ou ouvertures 5a, 5b permettant l'accès aux zones de connexion 3a, 3b du circuit d'antenne 3 peuvent être réalisées notamment par usinage ou au cours du surmoulage en ayant recours à un noyau occupant la cavité et/ou ouvertures.

Dans l'exemple, le corps de carte comprend un ou plusieurs percement(s) ou évidement(s) 5a, 5b qui permettent un accès aux zones de connexion 3a, 3b de l'antenne 3 à partir de l'extérieur du corps. L'antenne 3 est enfouie dans le corps de carte et comprend des zones de connexions 3a, 3B accessibles de l'extérieur du corps de carte 1.

Le procédé comprend également une étape de réalisation d'un micromodule 2 comprenant des plages de contact électrique 10 sur une face avant délimitées par une seconde périphérie P2 correspondant sensiblement ou étant légèrement inférieure à la première périphérie P1, des portions de connexion repliées vers une face arrière du micromodule opposée à la face avant.

Le micromodule 2 comprend ici un microcircuit intégré 8. Le micromodule est ici sensiblement conforme aux micromodules de carte à puce. Il comprend ici un enrobage E, des connexions 6 de puce aux différents contacts ou plages de contact. Le module est ici de type simple face. Les plages de contact ou conductrices sont réalisées d'un seul côté du module notamment par gravure ou contre-collage de métallisations. Le côté destiné à connecter un terminal à contact est pourvu de ces plages de contacts 10.

A la figure 3A, selon le premier mode de réalisation préféré, des plages de contacts 9 ou conductrices définissent une première périphérie P2 sensée délimiter la surface visible de contacts une fois le module inséré dans un corps de carte. Des plages de contact 9 comprennent des extensions 10 métalliques (portions, languettes, pattes de connexion) en prolongement des plages 9. Par exemple, pour connecter une antenne, deux extensions suffisent. Pour un objet plus complexe comme une carte multi-composant, plusieurs extensions 10 de plages peuvent être nécessaires.

Le micromodule comprend ici des plages de contact 11 en surface supérieure. Alternativement, les plages peuvent être sous un substrat support.

Ces portions de plages conductrices sont ensuite repliées avant insertion dans la cavité, vers la face opposée de celle portant les plages de contact, en fait en direction du corps support 1. Ces portions 10 sont ici repliées sensiblement à 90° vers la face portant la puce.

Les portions de plage 10 peuvent être supportées par un film diélectrique isolant. Le pliage peut être réalisé de manière à ce que la face conductrice de la portion soit orientée sensiblement dans une direction allant de la face avant vers la face arrière du module.

Selon une caractéristique, les portions de connexion qui s'étendent à partir de la première périphérie des plages de contact, sont configurées de manière qu'en position repliées, elles puissent exercer une force de contact élastique contre les zones de connexion après insertion dans la cavité.

Aux figures 4A au moins une portion 10 est configurée en angle sensiblement droit par rapport à la surface du micromodule de manière à se courber légèrement élastiquement à l'insertion. La déformation peut être élastique ou plastique et élastique de manière à conserver une certaine force de maintien du contact électrique.

Le procédé comprend également une étape d'insertion et de connexion du module dans la cavité, les portions de connexion étant mises en connexion électrique avec leur zone de connexion (3a, 3b) respective.

Dans l'exemple, pour la connexion, le micromodule après avoir les portions repliées, est encarté de manière classique dans la cavité 11 du corps de carte et fixé avec, par exemple, une couche thermo-adhésive G, de la colle cyanoacrylate, etc. comme illustré à la figure 4B.

Selon une caractéristique, les portions de connexion s'étendent à partir de la première périphérie des plages de contact ; Ces portions peuvent être configurées de manière à présenter une élasticité dans une direction sensiblement perpendiculaire à la surface principale des plages de contact.

Les portions sont dimensionnées de préférence avec une plus grande longueur que la profondeur des puits 5b, 5a de manière à être légèrement courbées notamment par flambage au cours de l'insertion. Un outil d'insertion peut exercer à cette opération, une force sur toute la surface du module pour le collage et déformation élastiques et/ou plastique des portions de connexion (jambes 10).

A la figure 5C, le module est conforme à celui de la figure 4A à la différence que les pattes ou portions de connexion 10 ont une longueur beaucoup plus importante que précédemment.

Dans ce mode de réalisation, au moins une portion 10 est configurée de manière à former un zigzag ou ressort élastique et/ou à se déformer élastiquement à l'insertion.

Préalablement à l'insertion, au moins une portion peut être repliée, configurée de manière à former une inclinaison vers l'intérieur du module (vers le centre du module) et à se déformer au moins élastiquement à l'insertion.

Alternativement le zigzag (ou plusieurs pliures sur une portion de connexion) peut être formé avant insertion notamment avant ou après le repliement des portions vers la face arrière du module.

Le procédé peut comprendre une étape de comblement au moins partiel de chaque évidement (5a, 5b) par une colle ou résine conductrice ou non. La colle / résine a pour fonction de fixer la portion en position de connexion élastique contre les zones de connexion. Le cas échéant, contrairement à la figure 5D, seul le fond des puits peut être comblé de colle / résine. Ainsi, une grande partie intermédiaire de la portion de connexion 10 est libre de mouvement entre son extrémité au contact de la zone de connexion et son raccordement à la plage de contact en surface externe du module au niveau de la ligne périphérique.

Bien que le module possède ici plusieurs portions de connexion notamment pour connecter un ou plusieurs circuit(s) de carte multi-composant, dans d'autres modes de réalisation, il peut comporter uniquement deux portions de connexions par exemple au niveau des plages C4, C8 selon l'ISO 7816 pour connecter une antenne.

## Revendications

1. Procédé de connexion de plages conductrices (9) d'un micromodule (2) à des zones de connexion (3a, 3b) accessibles d'un support (1) d'un objet portable (100), comprenant les étapes suivantes de :
- fourniture ou réalisation d'un corps 1 de l'objet portable comportant une cavité (11) de réception du micromodule et des zones de connexion accessibles dans ladite cavité, ladite cavité débouchant en surface du corps et étant délimitée à la surface du corps par une première périphérie (P1),
- réalisation d'un micromodule comprenant des plages de contact électrique (9) sur une face avant, délimitées par une seconde périphérie P2 correspondant sensiblement à la première périphérie P1, des portions de connexion (10) repliées vers une face arrière du micromodule opposée à la face avant,
- insertion du module dans la cavité, lesdites portions de connexion étant mises en connexion électrique avec leur zone de connexion (3a, 3b) respective,
**caractérisé en ce que** lesdites portions de connexion s'étendent à partir de la seconde périphérie (P2) des plages de contact et sont configurées de manière qu'en position repliée, elles exercent une force de contact contre les zones de connexion.

2. Procédé de connexion selon la revendication précédente, **caractérisé en ce qu'**au moins une portion est configurée en angle sensiblement droit par rapport à la surface du micromodule de manière à se courber élastiquement à l'insertion.

3. Procédé de connexion selon la revendication 1, **caractérisé en ce qu'**au moins une portion est configurée de manière à former un zigzag ou ressort élastique et à se déformer élastiquement à l'insertion.

4. Procédé de connexion selon la revendication 1, **caractérisé en ce qu'**au moins une portion est configurée de manière à former une inclinaison vers l'intérieur du module et à se déformer élastiquement à l'insertion.

5. Procédé de connexion selon la revendication précédente, **caractérisé en ce qu'il** comprend une étape de comblement au moins partiel de chaque évidement (5a, 5b).

6. Procédé de connexion selon la revendication précédente, **caractérisé en ce que** le comblement fixe ou colle uniquement l'extrémité des portions de manière à préserver leur élasticité.

7. Procédé selon la revendication précédente, **caractérisé en ce que** la matière de comblement est une matière conductrice effectuant un contact électrique entre lesdites portions (6a, 6b) et ladite zone de connexion correspondante (3a, 3b).

8. Objet portable comprenant un micromodule comportant des plages de contact électrique (9) sur une face avant délimitées par une seconde périphérie (P2) et des portions de connexion (10) repliées vers une face arrière du micromodule opposée à la face avant, **caractérisé en ce que** lesdites portions de connexion (10) s'étendent à partir de la seconde périphérie (P2) des plages de contact et sont configurées de manière à exercer une force de contact contre les zones de connexion.
